# EUROPÄISCHE PATENTANMELDUNG

(11) **EP 4 336 198 A1**
(43) Veröffentlichungstag der Anmeldung: **13.03.2024**
(21) Anmeldenummer: 23195588.1
(22) Anmeldetag: 06.09.2023
(51) Int. Cl.: G01R 31/387, G01R 31/388, G01R 31/396, G01R 31/00, G01R 31/385, B60L 50/64, B60L 58/18, H02J 7/00, H02J 7/34, H01M 10/44

(54) **BATTERIESYSTEM UND VERFAHREN ZUM BESTIMMEN EINER SPANNUNGSKENNLINIE EINES ELEKTRISCHEN ENERGIESPEICHERS**

(30) Priorität: 08.09.2022 DE 102022209368
(71) Anmelder: Siemens Mobility GmbH, 81739 München (DE)
(72) Erfinder: Fritsch, Matthias, 90762 Fürth (DE)
(74) Vertreter: Siemens Patent Attorneys

(57) **Zusammenfassung**

Die vorliegende Erfindung betrifft ein Verfahren zum Bestimmen einer Spannungskennlinie eines ersten Energiespeichers, wobei der erste Energiespeicher Teil eines wenigstens zwei Energiespeicher umfassenden Batteriesystems ist, wobei der erste Energiespeicher und der zweite Energiespeicher für ein gegenseitiges Laden und Entladen miteinander elektrisch verbunden sind, und wobei das Verfahren die folgenden Verfahrensschritte aufweist:
a) Entladen des ersten Energiespeichers n wenigstens den zweiten Energiespeicher oder Laden des ersten Energiespeichers unter Entladen wenigstens des zweiten Energiespeichers, und
b) Messen der Spannung an einer Mehrzahl von Ladungspunkten während Verfahrensschritt a), wobei die Ladungspunkte in einem für das Batteriesystem betrieblich relevanten Bereich eines Ladungszustands des ersten Energiespeichers, insbesondere ausschließlich in einem Bereich zwischen einschließlich 5 % und einschließlich 95 %, gemessen werden.

## Beschreibung

Die vorliegende Erfindung betrifft ein Verfahren zum Bestimmen einer Spannungskennline eines elektrischen Energiespeichers. Die vorliegende Erfindung betrifft ferner ein Batteriesystem, mit welchem ein derartiges Verfahren durchführbar ist.

Bei der Ausstattung von Batteriesystemen mit Energiespeichern, wie etwa bei der Ausstattung von Antriebssystemen mit Traktionsbatterien, sind meist vorgegebene Anforderungen zu erfüllen. Bei der Dimensionierung von Traktionsbatterien werden beispielsweise unterschiedliche Fahrszenarien herangezogen, um auf deren Basis eine Abschätzung des erforderlichen Energieinhaltes der Traktionsbatterie zu treffen bzw. die Traktionsbatterie entsprechend zu dimensionieren.

Während des Betriebs muss anschließend sichergestellt werden, dass die vorgesehene Energiemenge auch real vorhanden ist. Für diesen Zweck werden Ruhespannungskennlinien der Batterien (in Volt) sowie die verfügbare Batteriekapazität (in Amperestunden) verwendet, um den insgesamt zur Verfügung stehenden Energieinhalt (V x Ah = Wh) zu berechnen.

Ruhespannungskennlinien (Englisch Open-Circuit Voltage, abgekürzt OCV) variieren je nach verwendeter Zellchemie zum Teil stark. Diese Variation ist nicht nur auf vergleichbare Produkte unterschiedlicher Hersteller begrenzt, sondern kann aufgrund von Fertigungstoleranzen auch innerhalb mehrerer Chargen eines Lieferanten auftreten. Ferner können auch veränderte Materialzusammensetzungen der Aktivmaterialien zu unterschiedlichen Ruhespannungskennlinien führen. Darüber hinaus kann eine Veränderung durch Alterungseffekte auftreten.

Aktuelle Lösungen sehen häufig eine direkt hinterlegte Ruhespannungskennlinie vor, wodurch sich Abweichungen zu den realen Werten ergeben können. Aus diesem Grund ist eine energetische Überdimensionierung meist notwendig, um sicherzustellen, dass ausreichend elektrische Energie in den Energiespeichern bzw. der Traktionsbatterie gespeichert ist. Neben dieser energetischen Überdimensionierung ist die energieproportionale Aufteilung der abzugebenden Leistung auf einzelne Subsysteme durch Abweichungen von der OCV-Kennlinie beeinträchtigt.

Aus der Offenlegungsschrift DE 10 2020 007 408 A1 ist eine Batterieeinheit umfassend eine Batterie mit einer Mehrzahl von Batteriemodulen bekannt, wobei jedem Batteriemodul ein DC/DC-Wandler zugeordnet ist und wobei für eine Bestimmung einer Leerlaufspannung während eines Ladens bzw. Entladens einer Gruppe von Batteriemodulen Arbeitspunkte bezüglich eines Ladezustands und der korrespondierenden Leerlaufspannung angefahren werden.

Derartige Lösungen weisen somit noch weiteres Verbesserungspotential auf.

Es ist die Aufgabe der vorliegenden Erfindung, die aus dem Stand der Technik bekannten Nachteile zumindest teilweise zu überwinden und insbesondere eine Lösung bereitzustellen, durch welche die Sicherstellung und Ermittlung vorgegebener Kennwerte eines Energiespeichers verbessert werden können.

Die Lösung der Aufgabe erfolgt erfindungsgemäß zumindest zum Teil durch ein Verfahren und durch ein Batteriesystem mit den jeweiligen Merkmalen der unabhängigen Patentansprüche. Bevorzugte Ausgestaltungen der Erfindung sind in abhängigen Patentansprüchen, in der Beschreibung oder den Figuren beschrieben, wobei weitere in den Patentansprüchen oder in der Beschreibung oder den Figuren beschriebene oder gezeigte Merkmale einzeln oder in einer beliebigen Kombination einen Gegenstand der Erfindung darstellen können, wenn sich aus dem Kontext nicht eindeutig das Gegenteil ergibt.

Beschrieben wird ein Verfahren zum Bestimmen einer Spannungskennlinie eines ersten Energiespeichers, wobei der erste Energiespeicher Teil eines wenigstens zwei Energiespeicher umfassenden Batteriesystems ist, wobei der erste Energiespeicher und der zweite Energiespeicher für ein gegenseitiges Laden und Entladen miteinander elektrisch verbunden sind, und wobei das Verfahren die folgenden Verfahrensschritte aufweist:
a) Entladen des ersten Energiespeichers in wenigstens den zweiten Energiespeicher oder Laden des ersten Energiespeichers unter Entladen wenigstens des zweiten Energiespeichers, und
b) Messen der Spannung an einer Mehrzahl von Ladungspunkten während Verfahrensschritt a), wobei die Ladungspunkte in einem für das Batteriesystem betrieblich relevanten Bereich eines Ladungszustands des ersten Energiespeichers, insbesondere ausschließlich in einem Bereich zwischen einschließlich 5 % und einschließlich 95 %, gemessen werden.

Das beschriebene Verfahren dient somit dazu, eine Spannungskennlinie eines ersten Energiespeichers zu bestimmen. Der erste Energiespeicher kann beispielsweise eine Traktionsbatterie und als solche etwa Bestandteil eines Antriebssystems für ein elektrisch antreibbares Fahrzeug sein. Jedoch ist die Erfindung nicht grundsätzlich auf diese Anwendung beschränkt. Durch das Bestimmen der Spannungskennlinie wird es möglich, zu überprüfen, ob vorgegebene Spezifikationen des Energiespeichers vorliegen bzw. inwieweit diese von der gemessenen Spannungskennline abweicht.

Zur Durchführung des Verfahrens ist der erste Energiespeicher Teil eines wenigstens zwei Energiespeicher umfassenden Batteriesystems. Dabei sollten, wie nachfolgend ersichtlich, die Batteriespeicher zum gegenseitigen Laden beziehungsweise entladen miteinander verbunden sein. Dies soll im Sinne der vorliegenden Erfindung insbesondere bedeuten, dass der erste Energiespeicher in den zweiten Energiespeicher entladen werden kann und durch den zweiten Energiespeicher geladen werden kann. Ferner ist unter einem Batteriesystem insbesondere eine Einheit zu verstehen, welche gemeinsam in einer Endanwendung verwendet wird. Beispielsweise wird das Batteriesystem als elektrisches Antriebssystem verwendet.

Das beschriebene Verfahren weist zumindest die folgenden Verfahrensschritte auf.

Gemäß Verfahrensschritt a) erfolgt ein Entladen des ersten Energiespeichers in wenigstens den zweiten Energiespeicher oder ein Laden des ersten Energiespeichers unter Entladen wenigstens des zweiten Energiespeichers, wobei sich der zweite Energiespeicher auf den wenigstens einen zweiten Energiespeicher des Batteriesystems bezieht. In diesem Verfahrensschritt erfolgt somit ein Laden oder ein Entladen des ersten Energiespeichers unter Verwendung wenigstens eines zweiten Energiespeichers. Dabei kann sowohl nur ein zweiter Energiespeicher verwendet werden, oder es können der zweite und zumindest ein weiterer Energiespeicher verwendet werden. Die Verwendung von lediglich zwei Energiespeichern kann das Verfahren universeller und mit geringeren Anforderungen möglich machen, wohingegen das Verwenden von zumindest drei Energiespeichern besonders energiesparend oder mit geringerer Vorkonditionierung der Energiespeicher durchführbar sein kann, wie dies nachfolgend näher beschrieben ist.

Im Verlauf des Lade- oder Entladevorgangs des ersten Energiespeichers erfolgt ferner gemäß Verfahrensschritt b) das Messen der Spannung an einer Mehrzahl von Ladungspunkten während Verfahrensschritt a). In anderen Worten wird im Verlauf des Ladens oder Entladens bei unterschiedlichen Ladezuständen (Englisch State Of Charge, abgekürzt SOC) die Spannung gemessen. Dadurch wird es auf einfache Weise möglich, eine Spannungskennlinie aufzunehmen.

Das hier beschriebene Verfahren erlaubt es somit, ohne einen speziellen Teststand, sondern nur unter Verwendung des Batteriesystems als solchem eine Spannungskennlinie aufzunehmen. Der Aufwand, einen Energiespeicher hinsichtlich seines bereitgestellten Energieinhalts zu prüfen, kann daher deutlich reduziert werden.

Darüber hinaus wird es möglich, ein fertiggestelltes Batteriesystem unmittelbar vor oder auch nach dem Einbau in seiner Verwendungsposition zu testen. Dadurch kann eine sehr exakte Untersuchung unter Betriebsbedingungen erfolgen. Große Sicherheitspuffer des Energiegehalts können so bereits in der Auslegung entfallen, was eine verbesserte Ausnutzung des Energieinhalts des Energiespeichers erlaubt und somit Kosten reduziert.

Ferner ist es durch das beschriebene Verfahren auch ohne unverhältnismäßigen Aufwand möglich, Alterungseffekte der Energiespeicher bzw. deren Batteriezellen zu erkennen, da das Verfahren auch im Betrieb beziehungsweise in Ruhephasen des Batteriesystems in eingebautem Zustand problemlos und ohne zusätzlichen Personalaufwand durchführbar ist.

Wie vorstehend beschrieben kann es von besonderem Vorteil sein, wenn das Batteriesystem Teil eines Antriebssystems für ein elektrisch antreibbares Fahrzeug ist. Denn insbesondere in elektrisch antreibbaren Fahrzeugen ist ein hoher Grad an Standardisierung der Leistungsdaten erwünscht, so dass eine exakte und verlässliche und dabei einfach durchzuführende Ermittlung von Spannungskennlinien von großem Vorteil ist. Darüber hinaus ist insbesondere eine Messung der Spannungskennlinien im Betrieb bei Fahrzeugen aufgrund deren Mobilität schwierig. Erfindungsgemäß ist dies jedoch beispielsweise bei Ladephasen oder auch bei längerer Standzeit, wie etwa über Nacht, problemlos möglich.

Entsprechend kann es für eine Durchführung des Verfahrens von Vorteil sein, wenn das Batteriesystem in einem elektrisch antreibbaren Fahrzeug angeordnet ist, während die Verfahrensschritte a) und b) durchgeführt werden. So lassen sich etwa Alterungseffekte ermitteln, oder auch nach einem Austausch eines Energiespeichers kann dieser auf seine Spezifikationen überprüft werden und es kann eine Neuparametrierung der Ruhespannungskennlinie erfolgen.

Als weiterer Vorteil sei erwähnt, dass mit dem hier beschriebenen Verfahren eine Entkopplung der Fahrzeugsteuerung von der verwendeten Traktionsbatterie stattfinden kann, da diese nicht mehr vor Projektbeginn parametriert werden müsste, sondern allgemeingültig entwickelt und die Parameter eigenständig ermittelt werden können.

Nach einer Weiterbildung der Erfindung sind der erste Energiespeicher Teil eines ersten Batterie-Subsystems des Batteriesystems und der zweite Energiespeicher Teil eines zweiten Batterie-Subsystems des Batteriesystems. Derartige Batterie-Subsysteme werden oftmals auch als jeweiliger Zweig (Englisch Branch) bezeichnet. Sie umfassen meist den Energiespeicher mit einem jeweiligen DC/DC-Steller, um die Energiespeicher in einen gemeinsamen Zwischenkreis bzw. Gleichspannungszwischenkreis einzukoppeln. Vorteilhaft in dieser Ausgestaltung kann es insbesondere sein, dass die jeweiligen Subsysteme mit einer entsprechenden Peripherie ausgestaltet sind, was die entsprechenden Spannungs- und gegebenenfalls Strommessungen ohne Aufwand durchführbar machen lässt. Darüber hinaus zeigt diese Ausgestaltung, dass eben kein Teststand oder ähnliches benötigt wird, sondern dass das Verfahren im Wesentlichen nur mit dem Batteriesystem als solchem durchführbar ist.

Es ergibt sich ferner eine allgemeingültige Verwendung von OCV-Kennlinien bzw. Spannungskennlinien. Es braucht nicht mehr für jede Zellchemie eine Anpassung vorgenommen werden, sondern eine Kennlinie wird pro Zweig beziehungsweise für jedes Batterie-Subsystem hinterlegt.

Insbesondere in dieser Ausgestaltung aber nicht beschränkt hierauf kann nach einer Weiterbildung ferner vorgesehen sein, dass eine Messung der Spannung des ersten Energiespeichers derart erfolgt, dass für zumindest einen Teil der gemessenen Spannungswerte der Ladezustand des ersten Energiespeichers ermittelt wird. Beispielsweise kann für jeden ermittelten Spannungswert gleichermaßen der Ladezustand ermittelt werden. Der Ladezustand des Energiespeichers kann beispielsweise ermittelt werden, indem während des Lade- und Entladevorgangs die im DC/DC-Steller vorhandene Strommessung verwendet wird, um die Ladungsdifferenz beim Laden/Entladen aufzuzeichnen. Hierdurch wird es möglich, jedem Spannungswert einen entsprechenden SOC-Wert höchst genau zuzuordnen. Entsprechend wird die Spannungskennlinie noch exakter.

Nach einer Weiterbildung kann in dem Verfahrensschritt a) der erste Energiespeicher vollständig ent- oder geladen werden. In dieser Ausgestaltung kann eine vollständige Spannungskennline im Wesentlichen von einer Vollentladung bis zu einer Vollladung erzeugt werden. Dies ermöglicht prinzipiell eine umfassende Betrachtung der Leistungsfähigkeit auch bis in den Randbereich.

Erfindungsgemäß wird die Spannungskennlinie jedoch für einen während des Betriebs des Batteriesystems besonders relevanten Bereich der Ladezustände bestimmt. Entsprechend kann die Spannungskennlinie beispielsweise für einen Bereich des Ladungszustands von 5 % bis 95 %, insbesondere für einen Bereich von 10 % bis 90 %, aufgenommen werden.

Grundsätzlich kann das Verfahren derart durchgeführt werden, dass der erste Energiespeicher zunächst in wenigstens den zweiten Energiespeicher vollständig oder bis zu dem gewünschten Ladestartpunkt entladen wird und anschließend aus wenigstens dem zweiten Energiespeicher geladen wird, um die Spannungsmessungen durchzuführen.

Nach einer Weiterbildung wird in dem Verfahrensschritt b) zumindest zum Teil die Ruhespannung gemessen. Beispielsweise wird nur die Ruhespannung gemessen. In dieser Ausgestaltung kann somit eine Ruhespannungskurve ermittelt werden, was oftmals für eine exakte Kontrolle der Leistungsdaten des Energiespeichers von Vorteil sein kann, da eine sehr genaue und verlässliche Spannungskurve ermittelt werden kann. Um die Ruhespannung zu messen, wird vor entsprechenden Spannungsmessungen meist eine gewisse Relaxationszeit abgewartet.

Alternativ oder zusätzlich wird nach einer Weiterbildung in dem Verfahrensschritt b) zumindest zum Teil die Klemmenspannung gemessen. In dieser Ausgestaltung kann die Spannung unmittelbar bei einem Lade- oder Entladevorgang gemessen werden, was die Messung an sich vereinfachen kann. Beispielsweise kann eine derartige Messung vorzuziehen sein, wenn nur eine begrenzte Zeit zur Verfügung steht. Um dann jedoch vorteilhafte Ergebnisse zu erhalten, kann es von Vorteil sein, die Messungen der Klemmenspannung des erste Energiespeichers sowohl bei einem Ladevorgang und anschließend oder gegebenenfalls zu einer späteren Zeit bei einem Entladevorgang durchzuführen, oder umgekehrt.

Nach einer Weiterbildung werden der erste und wenigstens der zweite Energiespeicher derart vorkonditioniert, dass bei einem Entladen des ersten Energiespeichers die elektrische Energie vollständig wenigstens in den zweiten Energiespeicher überführt wird. Entsprechend kann unter einer Vorkonditionierung verstanden werden, dass vor einem Entladen des ersten Energiespeichers der zweite Energiespeicher sowie gegebenenfalls weitere Energiespeicher soweit entladen wird, dass dieser bzw. diese den Ladungsinhalt des ersten Energiespeichers aufnehmen kann bzw. können. Diese Ausgestaltung kann besonders energiesparend sein, da keine Energie aus dem entladenen Energiespeicher verloren geht bzw. beispielsweise in Wärme gewandelt werden muss, sondern vollständig in den zweiten und gegebenenfalls in weitere Energiespeicher fließen kann. Entsprechend ist es ersichtlich, dass bei dem Vorsehen von mehr als zwei Energiespeichern eine Vorkonditionierung vereinfacht sein kann, da jeder zu ladende Energiespeicher vergleichsweise wenig Ladungsinhalt des ersten Energiespeichers aufnehmen braucht.

Hinsichtlich weiterer Vorteile und technischer Merkmale des Verfahrens wird hiermit auf die Beschreibung des Batteriesystems, die Figuren und deren Beschreibung verwiesen.

Beschrieben wird ferner ein Batteriesystem, aufweisend wenigstens einen ersten Energiespeicher und einen zweiten Energiespeicher, wobei der erste Energiespeicher und der zweite Energiespeicher für ein gegenseitiges Laden und Entladen miteinander elektrisch verbunden sind, und wobei das Batteriesystem ferner eine Steuereinheit aufweist, die dazu ausgebildet ist, ein wie vorstehend beschriebenes Verfahren auszuführen.

Das Batteriesystem umfasst somit wenigstens zwei Energiespeicher, die bevorzugt jeweils Teil eines Batterie-Subsystems sind und somit in anderen Worten Teil eines jeweiligen Zweigs und damit unterschiedlicher Zweige des Batteriesystems sind. Die Subsysteme können etwa über einen DC/DC-Steller mit einem gemeinsamen Zwischenkreis verbunden sein. Dabei können nur zwei Subsysteme oder auch drei oder mehr Subsysteme vorgesehen sein.

Das Batteriesystem kann grundsätzlich Teil eines Antriebssystems für ein elektrisch antreibbares Fahrzeug, insbesondere für ein Schienenfahrzeug, sein, ist jedoch grundsätzlich nicht hierauf beschränkt. Entsprechend können die Energiespeicher Traktionsbatterien für das Fahrzeug bzw. Schienenfahrzeug sein.

Beispielhafte Energiespeicher umfassen etwa Batterien bzw. Akkumulatoren mit einer Vielzahl miteinander verschalteter Lithium-Ionen-Batteriezellen.

Das Batteriesystem weist ferner eine Steuereinheit auf, die dazu ausgebildet ist, ein vorstehend beschriebenes Verfahren auszuführen. Insbesondere kann eine entsprechende Software in dem Steuersystem hinterlegt sein, welche die jeweiligen Schritte ausführt, also insbesondere Laden- oder Entladen des ersten Energiespeichers und Durchführen entsprechender Spannungs- und gegebenenfalls Ladezustandsmessungen beziehungsweise Strommessungen.

Es ergeben sich somit im Wesentlichen die Vorteile, welche vorstehend bei dem Verfahren beschrieben sind, nämlich eine verbesserte und vereinfachte Ermittlung von Spannungskennlinien von Energiespeichern.

Hinsichtlich weiterer Vorteile und technischer Merkmale des Batteriesystems wird hiermit auf die Beschreibung des Verfahrens, die Figuren und deren Beschreibung verwiesen.

Weitere Einzelheiten, Merkmale und Vorteile des Gegenstandes der Erfindung ergeben sich aus den Patentansprüchen sowie aus der nachfolgenden Beschreibung der Figuren. In den Figuren zeigen:
- Fig. 1: eine Darstellung einer Ruhespannungskennlinie eines Energiespeichers,
- Fig. 2: eine Darstellung eines Teils eines Batteriesystems bei der Durchführung eines ersten Schritts des erfindungsgemäßen Verfahrens, und
- Fig. 3: eine Darstellung eines Teils eines Batteriesystems bei der Durchführung eines weiteren Schritts des erfindungsgemäßen Verfahrens.

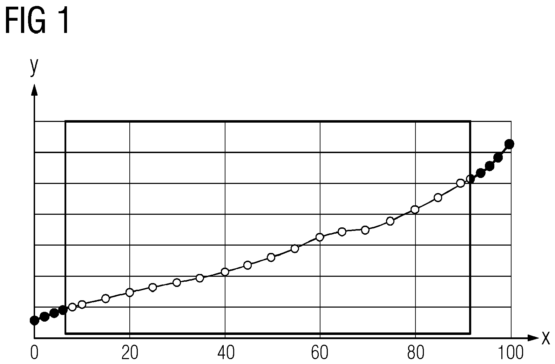

In der Figur 1 ist eine übliche Spannungskennline gezeigt, welche im Detail als Ruhespannungskennline ausgebildet ist. Eine derartige Spannungskennlinie dient insbesondere dazu, den Energiegehalt eines Energiespeichers 12, 14, 16 eines Batteriesystems 10 zu ermitteln, wenn sich der Energiespeicher 10 in unterschiedlichen Ladezuständen befindet. Dabei ist in der Figur 1 auf der X-Achse der Ladezustand (SOC) in % angegeben und ist auf der Y-Achse die Spannung, insbesondere die Ruhespannung, in Volt angegeben.

Ziel der vorliegenden Erfindung ist es, eine derartige Spannungskennlinie, insbesondere in dem beispielhaft gekennzeichneten Ladezustandsbereich zwischen 5 % und 95 %, zu ermitteln.

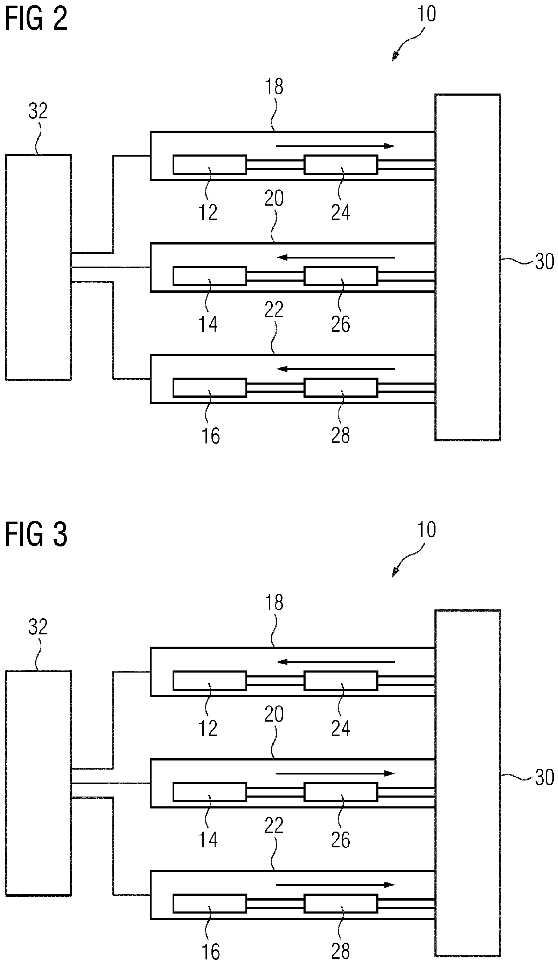

Dies wird in einem Batteriesystem 10 realisiert, welches in Teilen in den Figuren 2 und 3 bei unterschiedlichen Schritten des Verfahrens gemäß der Erfindung gezeigt ist. Das Batteriesystem 10 ist beispielsweise Teil eines Antriebssystems für ein elektrisch antreibbares Fahrzeug und somit bevorzugt in diesem angeordnet.

Ausweislich der Figuren 2 und 3 weist das Batteriesystem 10 drei Batterie-Subsysteme 18, 20, 22 auf, welche jeweils einen Energiespeicher 12, 14, 16 mit jeweils einer Vielzahl entsprechend der gewünschten Spannung und Kapazität miteinander verschalteter Lithium-Ionen-Batteriezellen. Die Energiespeicher 12, 14, 16 sind zum gegenseitigen Laden und Entladen miteinander elektrisch verbunden. Entsprechend weisen die Batterie-Subsysteme 18, 20, 22 jeweils eine Phase oder einen jeweiligen DC/DC-Steller 24, 26, 28 auf, welche die Batterie-Subsysteme 18, 20, 22 in einen Zwischenkreis 30 koppelt.

Es ist weiterhin eine Steuereinheit 32 gezeigt, welche Lade- und Entladevorgänge der Energiespeicher 12, 14, 16 steuern kann. Insbesondere ist die Steuereinheit 32 dazu ausgebildet, ein wie nachfolgend beschriebenes Verfahren auszuführen, was durch eine entsprechende Software, welche Steuerbefehle ausgibt, realisierbar sein kann.

Im Detail dient das Verfahren dazu, eine Spannungskennlinie des ersten Energiespeichers 12 zu ermitteln unter Verwendung des zweiten Energiespeichers 14 und des dritten Energiespeichers 16. In entsprechender Weise kann das Verfahren ebenfalls ausgeführt werden, um die Spannungskennlinie des zweiten Energiespeichers 14 und dritten Energiespeichers 16 zu ermitteln, so dass Spannungskennlinien sämtlicher Energiespeicher 12, 14, 16 ermittelbar sind.

Das Ermitteln der Spannungswerte startet beispielsweise bei einem Zustand des Batteriesystems 10, bei dem sämtliche Energiespeicher 12, 14, 16 einen Ladezustand von 50 % aufweisen, wobei im Folgenden von einer Ausgestaltung ausgegangen wird, bei welcher die Energiespeicher 12, 14, 16 baugleich sind und das gleiche Lade-/Entladeverhalten zeigen. Die Ladezustände können etwa durch eine entsprechende Vorkonditionierung eingestellt werden, indem beispielswiese jeweils Energie in weitere, hier nicht gezeigte, Energiespeicher transferiert wird. Derartige Energiespeicher können lokale Energiespeicher sein, die getrennt sind von dem Batteriesystem 10, oder die auch Bestandteil des Batteriesystems 10 sein können und etwa in einem weiteren Subsystem vorliegen.

Dann kann in einem ersten Schritt, um einen vollständigen Ladevorgang zu ermöglichen, der erste Energiespeicher 12 unter Laden des zweiten Energiespeichers 14 und des dritten Energiespeichers 16 zunächst vollständig entladen werden. Dies ist in der Figur 2 dargestellt. Es resultiert ein Zustand, bei dem der erste Energiespeicher 12 einen Ladezustand von 0 % aufweist und der zweite Energiespeicher 14 und der dritte Energiespeicher 16 jeweils einen Ladezustand von 75 % aufweisen.

Nach diesem Verfahrensschritt kann die eigentliche Spannungsmessung erfolgen, indem, wie in der Figur 3 dargestellt, der erste Energiespeicher 12 vollständig auf einen Ladezustand von 100 % aufgeladen wird, so dass der zweite Energiespeicher 14 und der dritte Energiespeicher 16 jeweils auf einen Ladezustand von 25 % entladen werden. Bei diesem Ladevorgang des ersten Energiespeichers 12 können Spannungsmessungen erfolgen, etwa gemeinsam mit einer Ermittlung des Ladezustands zu den Spannungsmessungen, um so eine Spannungskennlinie zu erhalten. Diese Spannungsmessungen werden dabei insbesondere in dem Bereich zwischen 5 % und 95 % des Ladezustands des ersten Energiespeichers 12, wie er in der Figure 1 angegeben ist, durchgeführt, da dies der für den normalen Betrieb des Batteriesystems 10 relevante Bereich ist. Somit lässt sich innerhalb der Grenzen des Batteriesystems 10 die Ruhespannung oder auch die Klemmenspannung im betrieblich relevanten Bereich aufzeichnen und innerhalb der Fahrzeugsteuerung abspeichern.

## Patentansprüche

1. Verfahren zum Bestimmen einer Spannungskennlinie eines ersten Energiespeichers (12), wobei der erste Energiespeicher (12) Teil eines wenigstens zwei Energiespeicher (12, 14, 16) umfassenden Batteriesystems (10) ist, wobei der erste Energiespeicher (12) und der zweite Energiespeicher (14) für ein gegenseitiges Laden und Entladen miteinander elektrisch verbunden sind, und wobei das Verfahren die folgenden Verfahrensschritte aufweist:
a) Entladen des ersten Energiespeichers (12) in wenigstens den zweiten Energiespeicher (14) oder Laden des ersten Energiespeichers (12) unter Entladen wenigstens des zweiten Energiespeichers (14), und
b) Messen der Spannung an einer Mehrzahl von Ladungspunkten während Verfahrensschritt a), wobei die Ladungspunkte in einem für das Batteriesystem (10) betrieblich relevanten Bereich eines Ladungszustands des ersten Energiespeichers (12), insbesondere ausschließlich in einem Bereich zwischen einschließlich 5 % und einschließlich 95 %, gemessen werden.

2. Verfahren nach Anspruch 1, **dadurch gekennzeichnet, dass** der erste Energiespeicher (12) Teil eines ersten Batterie-Subsystems (18) des Batteriesystems (10) ist und der zweite Energiespeicher (14) Teil eines zweiten Batterie-Subsystems (20) des Batteriesystems (10) ist.

3. Verfahren nach Anspruch 1 oder 2, **dadurch gekennzeichnet, dass** eine Messung der Spannung des ersten Energiespeichers (12) derart erfolgt, dass für zumindest einen Teil gemessener Spannungswerte der Ladezustand des ersten Energiespeichers (12) ermittelt wird.

4. Verfahren nach einem der vorstehenden Ansprüche, **dadurch gekennzeichnet, dass** in dem Verfahrensschritt a) der erste Energiespeicher (12) vollständig ent- oder geladen wird.

5. Verfahren nach einem der vorstehenden Ansprüche, **dadurch gekennzeichnet, dass** in dem Verfahrensschritt b) zumindest zum Teil eine Ruhespannung gemessen wird.

6. Verfahren nach einem der vorstehenden Ansprüche, **dadurch gekennzeichnet, dass** in dem Verfahrensschritt b) zumindest zum Teil eine Klemmenspannung des ersten Energiespeichers (12) gemessen wird.

7. Verfahren nach einem der vorstehenden Ansprüche, **dadurch gekennzeichnet, dass** der erste Energiespeicher (12) und wenigstens der zweite Energiespeicher (14) derart vorkonditioniert werden, dass bei einem Entladen des ersten Energiespeichers (12) die elektrische Energie vollständig in wenigstens den zweiten Energiespeicher (14) überführt wird.

8. Verfahren nach einem der vorstehenden Ansprüche, **dadurch gekennzeichnet, dass** das Batteriesystem (10) Teil eines Antriebssystems für ein elektrisch antreibbares Fahrzeug, insbesondere ein Schienenfahrzeug, ist.

9. Verfahren nach Anspruch 8, **dadurch gekennzeichnet, dass** das Verfahren ausgeführt wird, wenn das Batteriesystem (10) in einem elektrisch antreibbaren Fahrzeug angeordnet ist.

10. Batteriesystem (10), aufweisend wenigstens einen ersten Energiespeicher (12) und einen zweiten Energiespeicher (14), wobei der erste Energiespeicher (12) und der zweite Energiespeicher (14) für ein gegenseitiges Laden und Entladen miteinander elektrisch verbunden sind, und wobei das Batteriesystem (10) ferner eine Steuereinheit (32) aufweist, die dazu ausgebildet ist, ein Verfahren nach einem der Ansprüche 1 bis 9 auszuführen.
